Europäisches Patentamt

European Patent Office

Office européen des brevets

(11) Publication number: 0 129 732 A1

(12) EUROPEAN PATENT APPLICATION

(21) Application number: 84106073.4

(22) Date of filing: 28.05.84

(51) Int. Cl.⁴: H 05 K 13/00

(30) Priority: 15.06.83 US 504766

(43) Date of publication of application:
02.01.85 Bulletin 85/1

(84) Designated Contracting States:
CH DE FR GB IT LI NL

(71) Applicant: THE PERKIN-ELMER CORPORATION
Main Avenue
Norwalk Connecticut 06856(US)

(72) Inventor: Engelbrecht, Orest
66 Nature View Trail
Bethel Connecticut 06801(US)

(74) Representative: Patentanwälte Grünecker, Dr.
Kinkeldey, Dr. Stockmair, Dr. Schumann, Jakob, Dr.
Bezold, Meister, Hilgers, Dr. Meyer-Plath
Maximilianstrasse 58
D-8000 München 22(DE)

(54) Wafer transferring chuck assembly.

(57) A wafer chuck assembly having elevator means for accepting a wafer and placing it precisely on a platen without changing its spatial orientation.

FIG. I

Croydon Printing Company Ltd.

'0129732

.TE
.STOCKMAIR
────ULD · MEISTER
HILGERS · DR. MEYER · PLATH

## WAFER TRANSFERRING CHUCK ASSEMBLY

## BACKGROUND OF THE INVENTION

In the fabrication of integrated circuits the silicon wafers on which circuits are formed must undergo a large number of processing steps. For example, each wafer must be coated, exposed, developed, etched and recoated many times as the integrated circuits on the wafers are built up layer by layer. For many of these processing steps the wafer must first be aligned before being placed at the work station for processing. Thus, in many wafer handling systems the wafer is transported to an alignment station and then after alignment transported to the work station.

After alignment it is most important that the wafer be delivered to the work station without disturbing its previously aligned condition. The present invention relates to a chuck assembly for accomplishing the foregoing.

## BRIEF SUMMARY OF THE INVENTION

The present invention relates to a chuck assembly which receives a wafer and precisely places it on a platen without disturbing its spatial orientation.

The chuck assembly of the present invention comprises a platen disposed within a housing. The platen is adapted to receive a wafer which is secured thereto by means of openings in the surface thereof which communicate with a source of vacuum.

The housing also has disposed therein a wafer lifter mechanism which may be raised to accept a wafer positioned over the platen and lowered to place the wafer onto the platen. The wafer lifter mechanism comprises a base assembly which has a cylinder for receiving a piston means. The cylinder is airtight and pressurized air introduced or exhausted therefrom raises or lowers the piston means. Fixed to one end of the piston means is a flexible rubber cup to which vacuum may be applied to secure a wafer thereto. A flexure is fixed to the base assembly and the piston means to prevent rotational movement of the piston means when it is raised and lowered so that the spatial orientation of the wafer is undisturbed when it is deposited onto the platen.

## BRIEF DESCRIPTION OF THE DRAWING

Figure 1 is a view partly in section of the chuck assembly of the present invention;

Figure 2 is an enlarged view of the wafer lifter mechanism of Figure 1, and;

Figures 3a and 3b are top and side views of the flexure of the present invention.

## DESCRIPTION

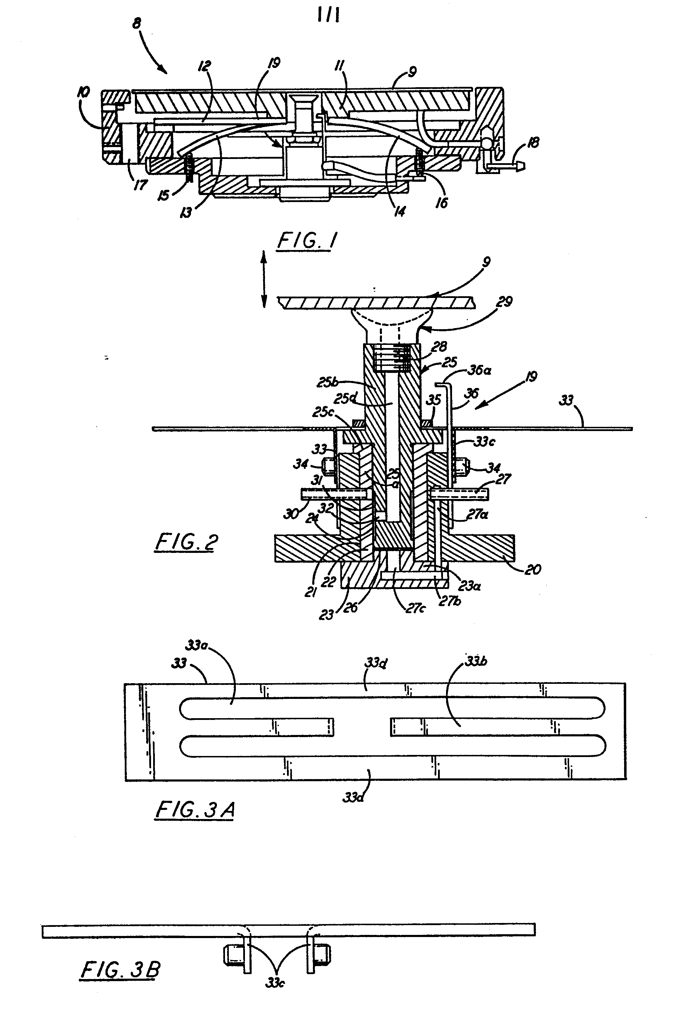

Figure 1 illustrates the chuck assembly 8 of the present invention. The chuck assembly 8 comprises housing 10 as shown. A platen 11 is disposed within housing 10 and provides a surface for supporting a wafer 9. A suspension spring 12 fixed to housing 10 and platen 11 along with preload springs 13 and 14 act against set screws 15 and 16, respectively, to cause the platen to be spring loaded in an outward direction.

The suspension spring 12 also aids in retaining platen 11 within housing 10. Further means (not shown) may be inserted through opening 17 in housing 10 to hold platen 11 within housing 10 as well as centrally positioned therein regardless of the orientation of the chuck assembly. This also prevents undue stress from being placed on suspension spring 12 should the chuck assembly be tilted or turned upside down.

A conduit 18 passes through housing 10 and is connected to platen 11 via tube 18a to be connected to platen 11. By means of a manifold and small openings in the surface of the platen 11 wafer 9 may be held fast by application of vacuum to conduit 18.

A wafer lifter mechanism is centrally located within the chuck assembly 8. Wafer lifter mechnaism 19 is shown enlarged in Figure 2.

As shown in Figure 2 wafer lifter mechanism comprises a base 20 fixed to chuck assembly housing 10 by any convenient means. The base 20 has a central opening 21 into which is force fitted bushing 22. An element 23 has an extension which is force fitted in the bottom of an opening 24 formed in bushing 22.

Piston means 25 has a shaft portion 25a which is slidably disposed within opening 24 of bushing 22. Bushing 22, element 23 and shaft 25a of piston means 25 from an airtight volume 26 which is just visable in Figure 2 but which enlarges as shaft 25 is moved in an upwardly direciton.

A conduit 25 communicates with volume 26 via conduit 27a in base 20 and conduits 27b and 27c in element 23 substantially as shown.

Piston means 25 has an upper portion 25b. A shoulder 25c formed in piston means 25 abuts the upper end of bushing 22 when piston means 25 is in its normal down position as shown in Figure 2.

A relatively solid element 28 is fixed, e.g., by a force fit into recess 25d of piston means 25. A flexible rubber cup 29 is attached to solid element 28.

Piston means 25 has a bore 25d. A conduit 30 communicates with bore 25d via an indentation 31 formed in shaft 25 and a conduit 32. The indentation 31 is of a length that the bore 25d does not lose communication with conduit 30 over the length that piston means 25 is designed to travel.

Flexible rubber cup 29 and element 28 have a common bore which connects with bore 25d and conduit 30 to permit vacuum to be applied to the surface of flexible rubber cup 29.

A flexure 33 fixed between piston 25 and base 20 functions to prevent rotational movement of the piston as it is raised and lowered.

Figures 3a and 3b show flexure 33 to be a unitary relatively thin device made of stainless steel or other suitable material.

Figure 3a shows a top view of the flexure 33. The Flexure 33 may be stamped out to provide cut-out area 33a. Arm 33 is cut at the center and its two ends are bent to form tabs 33c. The tabs 33c are fixed to base 20, e.g., by means of screws 34.

The flexure is fixed to piston means 25 by fixing neck portions 33d between shoulder 25c and a washer type element 35 by means of suitable epoxy adhesive.

Thus, when piston 25 is raised the flexure 33 is flexed to permit the neck portions 33d to move with the piston 33 while the tabs 33d remain fixed to the base. Thus, flexure 33 prevents rotational movement or play of the piston during its rise or lowering.

A stop 36 has an end secured to base 20, e.g., by one of screws 34 and another end bent to form extension 36a which abuts against shoulder 25c to prevent piston 25 from being raised beyond a predetermined amount.

By means of a close fit of bushing with shaft 25a radial play of the piston 25 as shaft 25a moves up and down in opening 24 is prevented.

In operation, pressurized air is introduced into volume 26 via conduit 27. This forces piston up until shoulder 25c meets extension 36a of stop 36. In the raised position flexible rubber cup 29 now with vacuum applied grasps the wafer 9 and lifts it off, e.g., an input shuttle which has positioned the wafer 9 over the platen. The shuttle is then removed. The wafer 9 is then slowly lowered to platen 11 by switching from the positive pressure needed to lift piston 25 to atmosphere through a restrictor (not shown) in conduit 27. The rate of descent is essentially controlled by the size of the restrictor with gravity supplying the most downward force and the closing of the flexure 33 to its normal position supplying some of the downward force. Once the piston 25 is retracted to its home position, vacuum may be applied to conduit 27 to assure that shaft 25a is completely nested.  As aforesaid, flexure 33 functions to prevent rotational movement of piston 25 and, thus, the previously aligned condition of the wafer is preserved when it is deposited on the platen 11 for processing.

After the wafer is lowered onto platen 11, vacuum is removed from the flexible rubber cup 29 and applied to platen 11 via conduit 18.  This releases the wafer 9 from the rubber cup 29 and holds it fast on the platen 11,  permitting a work process to be performed on the wafer.  During lowering of the wafer to the platen, this spatial orientation is unchanged.  The spatial orientation of the wafer is also preserved when the vacuum is switched from the rubber cup 29 to platen 11.  Since the wafer is then held securely by the platen 11, work may be performed thereof in any appropriate position.

When processing is finished, vacuum is removed from the platen 11 and the wafer is lifted off the platen by applying pressurized air again to conduit 27 to force piston upward with vacuum applied to rubber cup 29 to hold the wafer secure.  This permits the wafer to be retrieved by an output shuttle after vacuum is removed from the rubber cup.

Other modifications of the present invention are possible in light of the above description which should not be deemed as placing limitations on the invention other than those expressly set forth in the claims which follow:

## WHAT IS CLAIMED IS:

1. A chuck assembly for receiving a wafer without disturbing its spatial orientation, comprising,

housing means,

platen means disposed in said housing,

wafer lifter means centrally disposed in said housing means for grasping and depositing the wafer onto said platen means,

said wafer lifter means comprising,

base means,

piston means disposed in said base means movable in the vertical direction relative to said base means,

flexure means connected between said base means and said piston means preventing rotational movement of said piston means when it is moved in the vertical driection.

2. A chuck assembly according to Claim 1 wherein,

said piston means has a shaft at one end,

said base means has a cylinder formed therein for receiving said shaft,

bearing means disposed in said cylinder for preventing radial movement of said piston means when it is moved in the vertical direction.

3. A chuck assembly according to Claim 2 further comprising,

first conduit means communicating with said cylinder,

said platen means having a central opening located over said piston means,

whereby application of pressurized air to said first conduit means causes said piston means to be raised through said central opening and withdrawal of said pressurized air source causes said piston means to be lowered.

4. A check assembly according to Claim 3 wherein said piston means comprises,

a flexible cup fixed to the other end of said piston means,

second conduit means for applying vacuum to said flexible cup such that on coming into contact with the wafer said flexible cup secures the wafer by suction.

5. A chuck assembly according to Claim 4 wherein said second conduit means comprises,

at least one orifice extending through said flexible cup and opening at the surface thereof,

a bore in said shaft communicating at one end with said orifice,

means connecting said bore externally of said housing to permit vacuum to be applied to said orifice within predetermined vertical positions of said piston means.

6. A chuck assembly according to Claim 5 wherein said platent means includes,

means for applying vacuum to the surface thereof to secure a wafer deposited therein.

7. A chuck assembly according to Claim 1 wherein said flexure means comprises,

a thin elastic cut-out including,

an inner arm split in the center to form two ends,

each of said ends fixed to said base means,

a pair of outer arms fixed at their centers to said piston means.

8. A chuck assembly according to Claim 2 wherein said flexure means comprises,

a thin elastic cut-out having,

an inner arm split on the center to form two ends,

each of said ends fixed to said base means,

a pair of outer arms fixed at their centers to said piston means.

9. A check assembly according to Claims 3 wherein said flexure means comprises,

a thin elastic cut-out having,

an inner arm split on the center to form two ends,

each of said ends fixed to said base means,

a pair of outer arms fixed at their centers to said piston means.

10. A chuck assembly according to Claim 3 wherein said flexure means comprises,

a thin elastic cut-out having,

an inner arm split on the center to form two ends,

each of said ends fixed to said base means,

a pair of outer arms fixed at their centers to said piston means.

11. A chuck assembly according to Claim 4 wherein said flexure means comprises,

a thin elastic cut-out having,

an inner arm split on the center to form two ends,

each of said ends fixed to said base means,

a pair of outer arms fixed at their centers to said piston means.

12. A chuck assembly according to Claim 5 wherein said flexure means comprises,

a thin elastic cut-out having,

an inner arm split on the center to form two ends,

each of said ends fixed it said base means,

a pair of outer arms fixed at their centers to said piston means.

13. A chuck assembly according to Claim 6 wherein said flexure means comprises,

a thin elastic cut-out having,

an inner arm split on the center to form two ends,

each of said ends fixed to said base means,

a pair of outer arms fixed at their centers to said piston means.

FIG. 1

FIG. 2

FIG. 3A

FIG. 3B

1/1

European Patent
Office

**EUROPEAN SEARCH REPORT**

**0129732**
Application number

EP 84 10 6073

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | US-A-3 711 081  (IBM)<br>* column 7, lines 39-57; figures 13,14 * | 1,6 | H 05 K  13/00 |
| A | US-A-3 820 647  (TEXAS INSTR.)<br>* column 2, lines 45-60; figure 2 * | 1,6 | |
| A | GB-A-1 134 057  (ASSOC. SEMICONDUCTOR MAN.)<br>* page 1, lines 60-74; figure 2 * | 1,6 | |

**TECHNICAL FIELDS SEARCHED (Int. Cl. ³)**

H 05 K

The present search report has been drawn up for all claims

| Place of search | Date of completion of the search | Examiner |
|---|---|---|
| THE HAGUE | 25-09-1984 | LOMMEL A. |